# DEMANDE DE BREVET EUROPEEN

(11) **EP 0 614 235 A1**
(43) Date de publication de la demande: **07.09.1994**
(21) Numéro de dépôt: 93400580.2
(22) Date de dépôt: 05.03.1993
(51) Int. Cl.: H01L 41/113, H01L 41/08

(54) **Structure piézoélectrique à rendement amélioré**

(71) Demandeur: USINES GABRIEL WATTELEZ S.A., F-78300 Poissy (FR)
(72) Inventeur: Wattelez, Denis, F-92600 Asnieres (FR)
(74) Mandataire: de Saint-Palais, Arnaud Marie

(57) **Abrégé**

La structure selon l'invention comprend un câble coaxial (2) enrobé dans une pièce massive (1) de répartition des contraintes, réalisée en un matériau élastiquement déformable et conçue de manière à ce qu'une force (F) exercée en un point quelconque de la pièce (1) se répercute sur une zone (Z) relativement importante de la surface du câble (2), et que le câble (2) reprenne sensiblement sa position initiale dès que cesse l'effort qui a provoqué sa déformation.

L'invention s'applique notamment à la détection et/ou à la localisation d'objets ou de personnes dans une aire de détection déterminée.

## Description

La présente invention concerne une structure piézoélectrique apte à détecter et à convertir en un signal électrique exploitable toute variation de pression exercée en une zone quelconque de sa surface et qui dépasse un seuil prédéterminé.

Elle s'applique notamment, mais non exclusivement, à la détection et/ou à la localisation d'objets ou de personnes dans une aire de détection déterminée pouvant présenter des dimensions importantes.

A ce titre, elle peut être utilisée dans un système de surveillance anti-intrusion, aussi bien à l'intérieur d'un local qu'à l'extérieur (protection périmétrique).

Elle peut également servir à la détection de personnes ou de véhicules sur une aire de passage, par exemple en vue d'un comptage et/ou d'une commande automatique (porte, barrière, etc...).

L'invention part de la constatation que certains câbles blindés utilisés couramment en électronique, qui comprennent une âme centrale conductrice recouverte successivement par une couche en matière électriquement isolante puis par un blindage électriquement conducteur habituellement constitué par une nappe de fils métalliques tressés, possédaient des propriétés piézoélectriques, en ce sens qu'une pression exercée sur le câble engendre un signal électrique entre ladite âme et ledit blindage.

Toutefois, jusqu'ici, ces propriétés piézoélectriques mesurables uniquement en laboratoire, dans des conditions bien déterminées, n'étaient pas exploitables notamment en raison de la géométrie et des propriétés mécaniques du câble.

En effet, l'amplitude du signal électrique émis à la suite d'une pression exercée sur le câble est d'autant plus importante que la zone affectée par cette pression présente une surface importante.

Or, en raison de la forme (habituellement cylindrique) du câble, cette zone demeure relativement faible. En outre, du fait de sa souplesse, le câble aura toujours tendance à se dérober à la contrainte en se déformant de façon rémanente, de sorte qu'une même pression, appliquée successivement en un même emplacement, pourra engendrer des signaux électriques très différents les uns des autres.

Pour tenter de s'affranchir de ces problèmes, on a essayé de réaliser la couche isolante du câble en un matériau ou une combinaison de matériaux possédant de plus grandes qualités piézoélectriques. Toutefois, sans véritablement résoudre tous les problèmes précédemment évoqués, cette solution s'est avérée très coûteuse et utilisable seulement dans un nombre très limité d'applications (dans lequel le coût de l'élément piézoélectrique n'est pas un facteur prépondérant). On a également proposé d'utiliser, dans un but similaire, des réseaux de câbles relativement complexes connectés à des circuits de mesure de haute sensibilité. Toutefois, le coût d'une installation de ce genre demeure très élevé.

L'invention a donc plus particulièrement pour but de supprimer tous ces inconvénients grâce à une structure piézoélectrique à rendement amélioré permettant d'utiliser des câbles blindés classiques et donc très peu coûteux, et qui permet de produire néanmoins des signaux électriques exploitables par des circuits électroniques standard et donc également peu coûteux.

Pour parvenir à ce résultat, l'invention propose d'enrober le câble blindé présentant des propriétés piézoélectriques dans une pièce de répartition des contraintes réalisée en un matériau déformable élastiquement et présentant, de préférence, des propriétés hydrodynamiques, de manière à ce que :
- une pression exercée en un point quelconque de la pièce se répercute sur une zone relativement importante de la surface du câble et, qu'en conséquence, le signal électrique engendré entre l'âme et le blindage du câble ait un niveau aussi élevé que possible ;
- la déformation provoquée à la suite de l'application de la pression engendre des contraintes axiales du câble, de type traction/compression ; et
- le câble reprenne sensiblement sa position initiale dès que cesse l'effort qui a provoqué sa déformation à l'intérieur de la pièce de répartition, de manière à ce qu'une même contrainte engendre toujours un même signal électrique.

Avantageusement, la pièce de répartition des contraintes pourra présenter la forme d'une bande, d'un tapis ou analogue, pouvant se poser ou se fixer, par exemple par collage, sur une surface horizontale, verticale, voire même, inclinée. Elle pourra également être enfoncée dans le sol ou même dans un matériau apte à répercuter des contraintes en pression.

Des modes d'exécution de l'invention seront décrits ci-après, à titre d'exemples non limitatifs, avec référence aux dessins annexés dans lesquels :
La figure 1 est une vue schématique, en perspective, d'une structure piézoélectrique selon l'invention ;
La figure 2 est une coupe axiale de la structure représentée figure 1 ;
La figure 3 est une vue schématique montrant la répartition des contraintes exercées sur le câble lorsqu'une pression est appliquée à la structure ;
La figure 4 est une vue schématique, en perspective, d'une structure piézoélectrique selon l'invention, réalisée sous la forme de bandes pouvant se disposer bout à bout et/ou côte à côte ;
La figure 5 est un schéma synoptique d'un circuit électronique de détection connecté à un câble piézoélectrique d'une structure selon l'invention ;
La figure 6 est une représentation schématique d'un circuit d'alarme connecté à une pluralité de câbles piézoélectriques ;
La figure 7 est une représentation schématique d'une structure selon l'invention dans laquelle les câbles piézoélectriques sont disposés selon une configuration matricielle ;
La figure 8 est une représentation schématique d'une structure en bande permettant une localisation sectorielle des variations de pression.

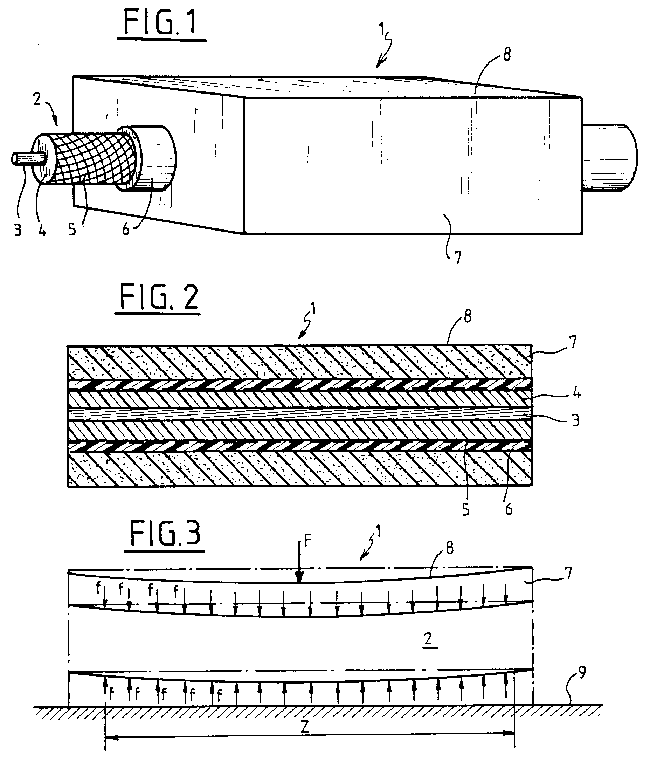

Telle que représentée sur les figures 1 à 3, la structure piézoélectrique 1 fait intervenir un câble blindé coaxial 2 comprenant, de façon classique, une âme centrale conductrice 3 recouverte successivement par une première gaine isolante 4 présentant des propriétés piézoélectriques, une gaine électriquement conductrice 5 (blindage) réalisée en fils conducteurs tressés, et une gaine extérieure 6 électriquement isolante qui recouvre la gaine conductrice 5.

Ce câble 2 est enrobé dans un bloc 7 en matière élastiquement déformable qui consiste ici en un agglomérat de granulats d'élastomère assemblés par un liant constitué par une résine de polyuréthanne, polymérisant à température ambiante.

L'avantage de ce matériau consiste en ce que ses propriétés mécaniques peuvent être ajustées en fonction de la nature des contraintes à détecter et/ou du milieu environnant, et ce, en jouant sur la dimension des granulats, sur la quantité de liant utilisée, sur la présence ou l'absence de bulles d'air (porosité éventuelle du matériau) sur la pression exercée au moulage et donc sur le taux de précontrainte des granulats d'élastomère, etc...

La figure 3 montre que si l'on applique une force F sur la face supérieure 8 d'une telle structure 1, dont la face inférieure repose sur une surface rigide 9, on provoque une déformation locale de cette structure et, parallèlement, une variation de pression (flèches f) sur une zone Z du câble 2 relativement importante (par rapport à la surface d'application de la force F), cette variation de pression affectant toute la surface cylindrique du câble 2 dans la zone Z.

En outre, le câble 2 est soumis à des contraintes en traction et en compression dans cette zone Z.

Par ailleurs, dès que cesse l'application de la force F, la structure reprend sa forme initiale (indiquée en traits interrompus), de sorte que la zone Z du câble 2 se trouve à nouveau soumise à une variation de pression.

Pour ces différentes raisons, l'effet piézoélectrique du câble 2, qui se traduit par l'émission d'un signal électrique entre l'âme centrale 3 et la gaine conductrice 5, lors d'une variation de pression, se trouve considérablement amplifié, se manifeste franchement et est donc plus facilement discernable.

Il devient donc possible d'utiliser des câbles coaxiaux classiques et peu coûteux, dont les propriétés piézoélectriques trop faibles pour être exploitables étaient jusqu'ici considérées comme des inconvénients (source de signaux électriques parasites).

Comme précédemment mentionné, la structure piézoélectrique selon l'invention peut être avantageusement réalisée sous la forme d'une bande incluant un ou plusieurs câbles piézoélectriques, cette bande pouvant être juxtaposée bout à bout ou côte à côte avec une ou plusieurs autres bandes identiques de manière à couvrir la surface souhaitée.

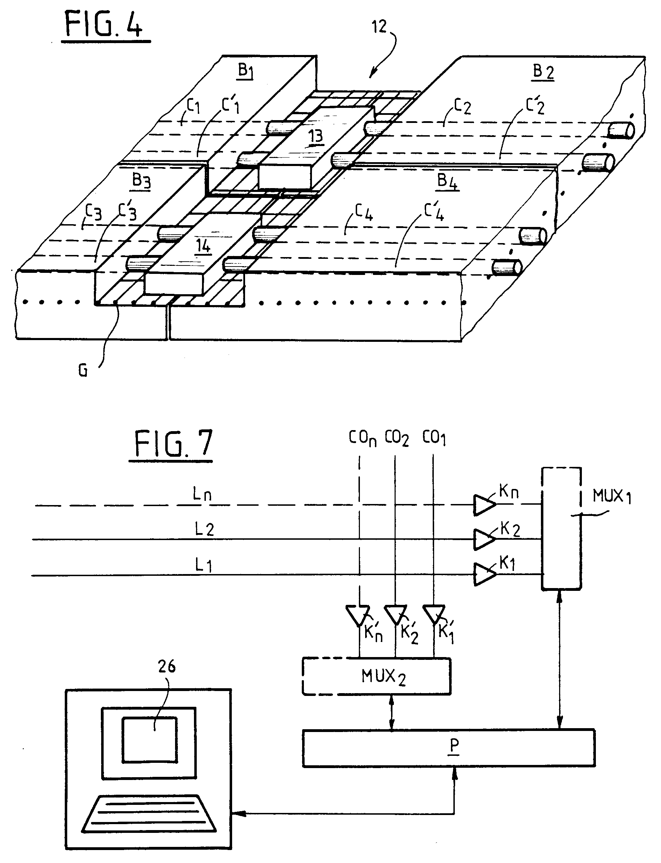

La figure 4 montre un assemblage de quatre bandes B₁ à B₄ renfermant chacune, noyés dans la matière élastiquement déformable, deux câbles C₁, C'₁ - C₂, C'₂ - C₃, C'₃ - C₄, C'₄, parallèles à l'axe longitudinal de la bande, qui reposent sur une grille de renforcement G en matière plastique qui s'étend dans un plan parallèle aux faces principales de la bande, à l'intérieur de celle-ci.

Dans cet exemple, les bandes B₁, B₃, disposées côte à côte, sont assemblées bout à bout avec les bandes B₂, B₄, qui sont elles-mêmes disposées côte à côte.

Les extrémités en regard des bandes sont bouvetées et délimitent un canal transversal 12 dans lequel dépassent les extrémités des câbles C₁, C'₁ - C₂, C'₂ - C₃, C'₃ - C₄, C'₄.

Ce canal 12 est utilisé pour loger les boîtes de jonction 13, 14 servant à raccorder les câbles.

Bien entendu, le nombre et la disposition des câbles contenus dans chaque bande sont fonction du type d'application et des résultats recherchés.

Le tapis obtenu par la juxtaposition des bandes B₁ à B₄ peut être disposé ou enfoui dans le sol. Il peut même être fixé par exemple par collage sur une paroi verticale ou même oblique.

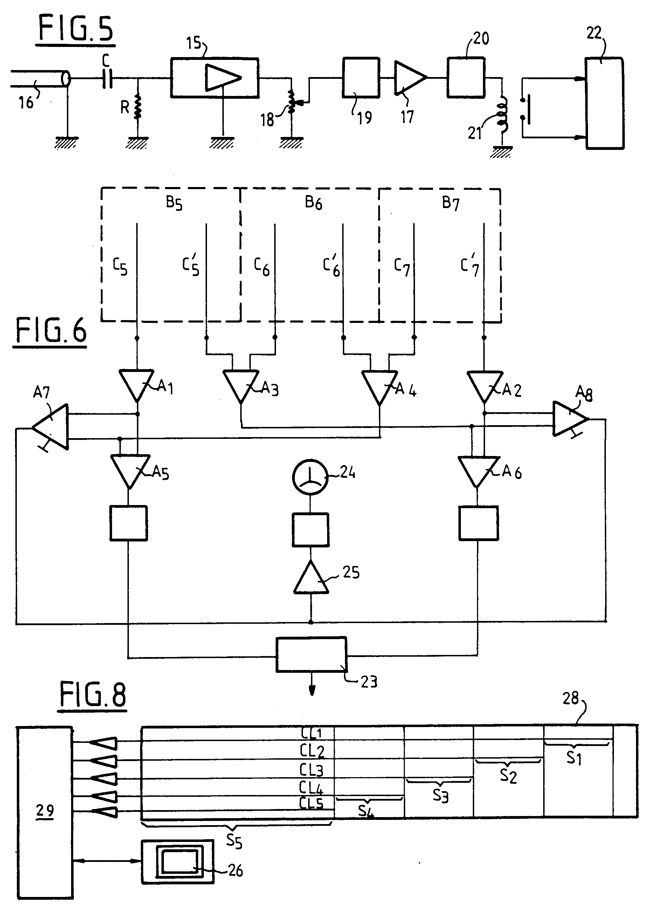

Le circuit de détection associé à chacun des câbles piézoélectriques de la structure peut comprendre, comme représenté sur la figure 5, un préamplificateur électrométrique 15 dont l'entrée est raccordée à l'âme du câble 16 par l'intermédiaire d'un filtre RC et dont la masse est reliée au blindage du câble 16. La sortie de ce préamplificateur 15 est connectée à l'entrée d'un amplificateur 17 par l'intermédiaire d'un potentiomètre de réglage du gain 18 et d'un écrêteur 19. La sortie de l'amplificateur 17 attaque une bascule 20 servant à actionner un relais 21 de commande par exemple d'un circuit d'alarme 22.

Bien entendu, l'invention ne se limite pas à un tel circuit de détection.

Ainsi, dans le cas d'un tapis de détection faisant intervenir trois bandes B₅, B₆, B₇ juxtaposées côte à côte et comprenant chacune deux câbles piézoélectriques C₅, C'₅ - C₆, C'₆ - C₇, C'₇, le circuit de détection pourrait faire intervenir, comme indiqué sur la figure 5 :
- un étage de préamplification comprenant deux préamplificateurs A₁, A₂, dont les entrées sont respectivement connectées aux câbles C₅ et C'₇ et deux préamplificateurs sommateurs, à savoir : un préamplificateur A₃ dont les entrées sont respectivement connectées aux câbles C'₅ et C₆, et un préamplificateur sommateur A₄ dont les entrées sont respectivement connectées aux câbles C'₆ et C₇ ; et
- un étage d'amplification comportant au moins deux amplificateurs différentiels, à savoir : un premier amplificateur différentiel A₅ dont les entrées sont respectivement connectées aux sorties des préamplificateurs A₁ et A₄, et un deuxième amplificateur différentiel A₆ dont les entrées sont respectivement connectées aux sorties des préamplificateurs A₃ et A₂.

Les sorties des amplificateurs A₅ et A₆ sont connectées aux entrées d'un circuit logique 23 (par exemple une porte OU) qui commande une alarme (non représentée).

Dans cet exemple, le circuit de détection comprend en outre un deuxième étage d'amplification, en parallèle vis-à-vis du premier, et qui comprend deux amplificateurs différentiels à gains réglables, à savoir : un premier amplificateur A₇ dont les entrées sont respectivement connectées aux sorties des préamplificateurs A₁ et A₄, et un deuxième amplificateur A₈ dont les entrées sont respectivement connectées aux sorties des préamplificateurs A₃ et A₂.

Les sorties des deux amplificateurs A₇ et A₈ sont reliées à un vu-mètre 24 par l'intermédiaire d'un circuit commun comprenant un amplificateur-conformateur 25 et une mémoire 26.

L'avantage du circuit précédemment décrit consiste en ce que les amplificateurs différentiels A₅, A₇ comparent les signaux électriques émis par les câbles C'₆ et C₇ (consécutifs) aux signaux émis par le câble C₅ situé à l'opposé du tapis, qui sert de référence (câble témoin), tandis que les amplificateurs différentiels A₆, A₈ comparent les signaux électriques émis par les câbles C'₅ et C₆ (consécutifs) aux signaux émis par le câble C'₇ (qui sert également de câble témoin) situé à l'opposé du tapis. De ce fait, il devient possible de s'affranchir des perturbations affectant l'ensemble des câbles et d'utiliser un circuit logique permettant d'effectuer une analyse des signaux détectés, par exemple en vue de la détermination d'un sens de passage.

Un autre avantage inhérent à la structure piézoélectrique elle-même, consiste en ce que les signaux électriques qu'elle émet se prêtent à des traitements électroniques simples et sont facilement numérisables.

L'invention ne se limite pas aux modes d'exécution précédemment décrits.

En effet, la structure piézoélectrique pourrait se présenter sous la forme d'un tapis carré ou rectangulaire dans lequel les câbles L₁, L₂... Lₙ - CO₁, CO₂... COₙ sont disposés de manière à constituer un réseau de type matriciel.

Dans ce cas, les sorties des amplificateurs K₁, K₂... Kₙ associés aux câbles L₁ constituant les lignes du réseau sont reliées à un processeur P par l'intermédiaire d'un premier multiplexeur MUX₁, tandis que les sorties des amplificateurs K'₁, K'₂... K'ₙ associés aux câbles CO₁, CO₂... COₙ constituant les colonnes du réseau sont reliées au processeur P par l'intermédiaire d'un second multiplexeur MUX₂.

Cette solution permet notamment de localiser l'emplacement où le tapis est soumis à une pression.

Cette localisation peut être indiquée sur l'écran de contrôle 26 connecté au processeur P.

Une telle localisation pourrait être également obtenue en utilisant, comme indiqué sur la figure 8, une structure piézoélectrique en forme de bande 28 renfermant des câbles piézoélectriques CL₁, CL₂, CL₃, CL₄, CL₅ de différentes longueurs, les signaux fournis par ces câbles étant alors traités de façon appropriée.

Dans ce cas, les sorties des amplificateurs associés à chacun de ces câbles CL₁ à CL₅ sont reliées à un circuit logique 29 connecté à un écran de contrôle 26, permettant de localiser le secteur S₁ à S₅ de la bande, soumis à une variation de pression, en fonction du nombre de câbles CL₁ à CL₅ réagissant à cette variation de pression.

## Revendications

1. Structure piézoélectrique apte à détecter et à convertir en un signal électrique exploitable une variation de pression exercée en une zone quelconque de sa surface, cette structure (1) utilisant au moins un câble blindé (2) comprenant une âme centrale conductrice (3) recouverte successivement par une couche électriquement isolante (4) puis par un revêtement électriquement conducteur (5),
caractérisée en ce que ledit câble (2) est enrobé dans une pièce massive (7) de répartition des contraintes réalisée en un matériau élastiquement déformable et conçue de manière à ce que :
- une pression exercée en un point quelconque de ladite pièce se répercute sur une zone (Z) relativement importante de la surface du câble (2) ;
- la déformation provoquée à la suite de l'application de ladite pression engendre des contraintes axiales du câble (2) en traction et en compression ; et
- le câble (2) reprenne sensiblement sa position initiale dès que cesse l'effort qui a provoqué sa déformation.

2. Structure piézoélectrique selon la revendication 1,
caractérisée en ce que la pièce de répartition des contraintes présente la forme d'une bande (B₁ à B₄) juxtaposable bout à bout ou côte à côte avec une ou plusieurs autres bandes identiques.

3. Structure piézoélectrique selon la revendication 2,
caractérisée en ce que la susdite pièce de répartition en forme de bande (B₁ à B₄) inclut un ou plusieurs câbles (C₁, C'₁ - C₂, C'₂ - C₃, C'₃ - C₄, C'₄) disposés parallèlement à son axe longitudinal.

4. Structure piézoélectrique selon la revendication 3,
caractérisée en ce que les susdits câbles (C₁, C'₁ - C₂, C'₂ - C₃, C'₃ - C₄, C'₄) reposent sur une grille de renforcement (G) qui s'étend à l'intérieur de la pièce de répartition, parallèlement à ses faces principales.

5. Structure piézoélectrique selon l'une des revendications précédentes,
caractérisée en ce que la pièce de répartition (7) est posée et/ou fixée sur une surface horizontale, verticale ou même inclinée.

6. Structure piézoélectrique selon la revendication 5,
caractérisée en ce que la pièce de répartition (7) est collée sur ladite surface.

7. Structure piézoélectrique selon l'une des revendications précédentes,
caractérisée en ce que la susdite pièce de répartition (7) est enfouie dans un matériau apte à répercuter des contraintes en pression.

8. Structure piézoélectrique selon l'une des revendications précédentes,
caractérisée en ce que le susdit câble (2) comprend une gaine extérieure (6) en matériau électriquement isolant recouvrant le revêtement électriquement conducteur (5).

9. Structure piézoélectrique selon l'une des revendications précédentes,
caractérisée en ce que le revêtement électriquement conducteur (5) est réalisé en fils électriquement conducteurs tressés.

10. Structure piézoélectrique selon l'une des revendications précédentes,
caractérisée en ce que la pièce de répartition des contraintes (7) consiste en un agglomérat de granulats d'élastomère assemblés par un liant.

11. Structure piézoélectrique selon la revendication 10,
caractérisée en ce que le susdit liant consiste en une résine polymérisant à température ambiante.

12. Structure piézoélectrique selon l'une des revendications 10 et 11,
caractérisée en ce qu'elle comprend au moins deux câbles, à savoir : un câble témoin (C₅) et au moins un câble de détection (C₇), ainsi qu'un circuit de détection de type différentiel (A₅) effectuant la différence entre les signaux émis par ces deux câbles (C₅, C₇).

13. Structure piézoélectrique selon l'une des revendications précédentes,
caractérisée en ce qu'elle se présente sous la forme d'un tapis carré ou rectangulaire et inclut deux séries de câbles (L₁, L₂... Lₙ - CO₁, CO₂... COₙ) constituant un réseau de type matriciel, reliées à un processeur (P) par l'intermédiaire de deux multiplexeurs respectifs (MUX₁, MUX₂).

14. Structure piézoélectrique selon l'une des revendications 1 à 12,
caractérisée en ce qu'elle présente la forme d'une bande (28) renfermant des câbles piézoélectriques (CL₁ à CL₅) de différentes longueurs, et en ce que le circuit électronique de détection associé à ces câbles (CL₁ à CL₅) comprend un circuit logique (29) apte à localiser le secteur de la bande soumis à une variation de pression, en fonction du nombre de câbles réagissant à cette variation de pression.
